Europäisches Patentamt

European Patent Office

Office européen des brevets

(19)

(11) **EP 0 713 580 B1**

(12) **EUROPÄISCHE PATENTSCHRIFT**

(45) Veröffentlichungstag und Bekanntmachung des Hinweises auf die Patenterteilung:
**24.09.1997 Patentblatt 1997/39**

(21) Anmeldenummer: **94921597.4**

(22) Anmeldetag: **26.07.1994**

(51) Int Cl.⁶: **G01R 31/34**, G01K 1/02

(86) Internationale Anmeldenummer:
**PCT/DE94/00863**

(87) Internationale Veröffentlichungsnummer:
**WO 95/04936 (16.02.1995 Gazette 1995/08)**

(54) **VERFAHREN UND VORRICHTUNG ZUR TEMPERATURÜBERWACHUNG EINES ELEKTRISCHEN GENERATORS**

PROCESS AND DEVICE FOR MONITORING THE TEMPERATURE OF AN ELECTRIC GENERATOR

PROCEDE ET DISPOSITIF PERMETTANT DE SURVEILLER LA TEMPERATURE D'UNE GENERATRICE ELECTRIQUE

(84) Benannte Vertragsstaaten:
**CH DE ES FR GB LI**

(30) Priorität: **09.08.1993 DE 4326680**

(43) Veröffentlichungstag der Anmeldung:
**29.05.1996 Patentblatt 1996/22**

(73) Patentinhaber: **SIEMENS AKTIENGESELLSCHAFT
80333 München (DE)**

(72) Erfinder:
 • **EMSHOFF, Horst-Werner
  D-45468 Mülheim an der Ruhr (DE)**
 • **INTICHAR, Lutz
  D-45472 Mülheim an der Ruhr (DE)**
 • **SCHEIL, Hermann
  D-91334 Hemhofen (DE)**

(56) Entgegenhaltungen:
 EP-A- 0 192 373          EP-A- 0 209 364
 DE-A- 3 535 550

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die Erfindung bezieht sich auf ein Verfahren zur Temperaturüberwachung eines elektrischen Generators, bei dem die Temperaturen einer Vielzahl von Wicklungsstäben der mit einem Külhmittel gekühlten, vorzugsweise wassergekühlten, Ständerwicklung des Generators erfaßt werden. Sie bezieht sich weiter auf eine Vorrichtung gemäß dem Oberbegriff des Anspruchs 5 zur Durchführung des Verfahrens. Ein derartiges Verfahren und eine derartige Vorrichtung sind aus der DE-A-35 35 550 und aus der EP-A-0 192 373 bekannt.

In einzelnen, wasserdurchströmten Hohlleitern von Wicklungsstäben wassergekühlter Generatorwicklungen können Teilleiterbrüche oder Teilleiterverstopfungen auftreten. Die Folge sind hohe, die Isolierung gefährdende lokale Aufheizungen (Heißpunkt-Temperatur). Da aus einer einfachen Messung der Gesamtwassererwärmung keine Aussage über Einzelwege in Wicklungsstäben möglich ist, muß auf der Warmwasserseite jedes Wicklungsstabes ein Temperaturfülher angeordnet sein. Aber auch ein Anstieg der Wassererwärmung eines einzelnen Wicklungsstabes infolge einer Durchflußstörung, bei der der anfängliche Volumenstrom kleiner und damit die Erwärmung größer wird, ist gering im Verhältnis zur Änderung einer lokalen Aufheizung. So kann z.B. eine Verstopfung von 10 % der Anzahl der Hohlleiter eines Wicklungsstabes nur einen geringen Anstieg der Wassererwärmung von 3 bis 4 K verursachen, obwohl bei ungünstiger Lage der verstopften Hohlleiter, z.B. wenn mehrere direkt nebeneinander liegende Hohlleiter verstopft sind, örtlich die zulässige Erwärmung der Isolierung bereits überschritten ist.

Während nun bei dem aus der DE-A-35 35 550 bekannten Überwachungssystem ein zulässiges Temperaturband dadurch definiert wird, daß ein maximal zulässiger Temperaturwert und ein minimal zulässiger Temperaturwert jeweils durch ein Polynom zweiten Grades des Generatorstroms bestimmt sind, werden bei dem aus der EP-A-0 192 373 bekannten Überwachungssystem zunächst aus einer Referenzmessung eine normierte Durchschnittstemperatur und für jeden Wicklungsstab ein Korrekturfaktor ermittelt. Bei einer aktuellen Überwachung führt dann bereits eine geringe Temperaturerhöhung eines einzelnen Wicklungsstabes zu einer relativ großen Abweichung von einer aktuell ermittelten und auf die normierte Durchschnittstemperatur bezogenen Durchschnittstemperatur. Bei diesem Überwachungssystem werden allerdings die Kühlwassertemperatur beinflussende betriebsbedingte Einflußgrößen ausschließlich bei der Referenzmessung berücksichtigt.

Der Erfindung liegt daher die Aufgabe zugrunde, ein Verfahren zur Temperaturüberwachung eines elektrischen Generators unter Berücksichtigung betriebsbedingter Einflußgrößen anzugeben. Dies soll bei einer geeigneten Überwachungsvorrichtung mit besonders einfachen Mitteln erreicht werden.

Bezüglich des Verfahrens wird die Aufgabe erfindungsgemäß gelöst durch die Merkmale des Anspruchs 1.

Die Erfindung beruht dabei auf der Erkenntnis, daß die Kühlwassertemperatur oder die Kühlwassererwärmung und damit die Erwärmung der Wicklungsstäbe nicht nur von Durchflußströrungen einzelner Wicklungsstäbe, sondern auch von betriebsrelevanten Parametern des Generators abhängen. Dabei sind die betriebsrelevanten Parameter diejenigen physikalischen Größen (Einflußgrößen), die die Erwärmung der Wicklungsstäbe beeinflussen, z.B. die Generatorspannung der Generatorstrom und/oder die Blindleistungsabgabe.

Die Funktionen jedes Parameters sind aus einer Anzahl von Lastpunkten, vorzugsweise aus mehr als drei unterschiedlichen Lastpunkten, bestimmt, auf die der Generator bei der Referenzmessung gefahren oder eingestellt wird. Die Kenngrößen sind zweckmäßigerweise die Koeffizienten eines für jeden Wicklungsstab gebildeten Polynoms, dessen Funktionen den Verlauf der betriebsrelevanten Parameter in Abhängigkeit von der Last oder von Betriebszuständen des Generators darstellen. Mittels der Funktionen werden somit die betriebsbedingten Einflußgrößen berücksichtigt.

Bei einer aktuellen Überwachung wird der Referenzwert für jeden Wicklungsstab zweckmäßigerweise ebenfalls aus einem für diesen Wicklungsstab gebildeten Polynom errechnet. Dabei wird das Polynom aus Funktionswerten der bei einem beliebigen Betriebszustand aktuell erfaßten Parametern gebildet, wobei die aus der Referenzmessung abgeleiteten Kenngrößen als Koeffizienten eingesetzt werden.

Als weitere sowohl bei der Referenzmessung als auch aktuell erfaßte betriebsrelevante Parameter werden zweckmäßigerweise zusätzlich zum Ständerstrom oder den Ständerströmen des Generators, zur Klemmenspannung des Generators, zur Blindleistung (Blindleistungsabgabe des Generators), zur Temperatur des Kühlwassers vor und nach Durchtritt durch die Wicklungsstäbe sowie zur Temperatur eines im Generator enthaltenen Kühlmittels, wie z.B. Wasserstoff, eine oder mehrere der folgenden Größen erfaßt: Der Kühlwasservolumenstrom oder die Differenz zwischen dem Druck des Kühlwassers vor und dem Druck des Kühlwassers nach Durchtritt durch die Wicklungsstäbe.

Die Erfassung der Vielzahl von Temperaturmeßwerten der Wicklungsstäbe sowohl bei der Referenzmessung als auch bei einer aktuellen Überwachung erfordert einen nicht unerheblichen Meßzeitraum. So müssen z.B. bis zu 216 Temperaturmeßwerte bei einer entsprechenden Anzahl von Wicklungsstäben erfaßt werden. Innerhalb dieses Meßzeitraums soll sich der Generator in einem Zustand der sogenannten thermischen Beharrung befinden, wobei die betriebsrelevanten Parameter oder Einflußgrößen annähernd konstant bleiben müssen und lediglich in einem vorgebbaren Toleranzband schwanken dürfen. Daher werden die zur Bildung des Referenzwertes dienenden betriebsrelevanten ParaMeter bei einem aktuellen Betriebszustand vorzugsweise innerhalb eines einstellbaren Meßzyklus periodisch gemessen. Dabei wird jeder gemessene Wert eines Parameters zur Feststellung einer Abweichung mit dem Wert einer vorherigen Periode des Meßzyklus verglichen. Eine thermische Beharrung ist dann erreicht, wenn am Ende des Meßzyklus bei jedem Parameter zwichen den Meßwerten dieses Parameters keine oder nur innerhalb des Toleranzbandes liegende Abweichungen vorliegen.

Bezüglich der Vorrichtung der eingangs genannten Art wird die Aufgabe erfindungsgemäß gelöst durch die kennzeichnenden Merkmale des Anspruchs 5.

In vorteilhafter Ausgestaltung umfaßt der zweite Baustein einen Speicher zur Ablegen der stabspezifischen Kenngrößen.

Die mit der Erfindung erzielten Vorteile bestehen insbesondere darin, daß durch ein Auswerteverfahren mit Hilfe von Polynomen unter Berücksichtigung von betriebsrelevanten Parametern oder von betriebsbedingten Einflußgrößen eine präzise und mindestens annähernd kontinuierliche Temperaturüberwachung der Wicklungsstäbe des Generators möglich ist.

Ein Ausführungsbeispiel der Erfindung wird anhand einer Zeichnung näher erläutert. Sie zeigt ein Funktionsschema mit zur Durchführung eines Überwachungsverfahrens vorgesehenen Komponenten.

Der zu überwachende, im Längsschnitt schematisch dargestellte Generator 2 umfaßt in einem Generatorgehäuse 4 einen Rotor 6 auf einer Welle 8 und eine Ständerwicklung 10. Die Wicklungsstäbe $S_i$ der wassergekühlten Ständerwicklung 10, von denen nur einige herausgezeichnet sind, sind zur Bildung der Ständerwicklung 10 elektrisch hintereinandergeschaltet. Jeder Wicklungsstab $S_i$, d.h. eine Anzahl von (nicht dargestellten) Teilleitern jedes Wicklungsstabes $S_i$ wird von Kühlwasser KW durchströmt. Dazu sind die Wicklungsstäbe $S_i$ zuströmseitig über isolierende Kunststoffschläuche 12 mit einer gemeinsamen Ringleitung 14 verbunden, in die kaltes Kühlwasser $KW_k$ einströmt. Das in den Wicklungsstäben $S_i$ erwärmte Kühlwasser $KW_w$ wird abströmseitig in einer weireren Ringleitung 16 gesammelt, die ebenfalls über Kunststoffschläuche 18 mit den einzelnen Wicklungsstäben $S_i$ verbunden ist. Das warme Kühlwasser $KW_w$ wird in einen durch Pfeile angedeuteten Kühlkreislauf 20 zurückgeführt und dort in nicht näher dargestellter Art und Weise rückgekühlt.

Auf der Abströmseite wird die Temperatur $T_i$ jedes Wicklungsstabes $S_i$ erfaßt. Dazu wird mittels einer der Anzahl der Wicklungsstäbe $S_i$ entsprechenden Anzahl von Temperatursensoren 21 - von denen der Übersicht halber nur einer schematisch dargestellt ist - die Temperatur $T_i$ des aus dem jeweiligen Wicklungsstab $S_i$ abströmenden erwärmten Kühlwassers $Kw_w$ gemessen. Als Temperatursensoren 21 für die bis zu 216 Wicklungsstäbe $S_i$ sind Thermoelemente oder Widerstandsthermometer vorgesehen. Die gemessenen Temperaturen $T_i = T_1, ... T_n$ der n Wicklungstäbe $S_i$ werden einem

Meßwerterfassungs- und Meßwertverarbeitungsbaustein 22 zugeführt. Diesem Baustein 22 werden als weitere Meßwerte die mittels eines Temperatursensors 24 auf der Zuströmseite der Wicklungsstäbe $S_i$ gemessene Temperatur $T_{Wk}$ des kalten Kühlwassers $KW_k$, die mittels eines Temperatursensors 26 gemessene Temperatur $T_{Ww}$ des aus der Ringleitung 16 ausströmenden, erwärmten Kühlwassers $KW_w$ aller Wicklungsstäbe $S_i$, die mittels Drucksensoren 28, 30 gemessenen Drücke $p_k$ und $p_w$ des kalten Kühlwassers $KW_k$ auf der Zuströmseite bzw. des erwärmten Kühlwassers $KW_w$ auf der Abströmseite der Wicklungsstäbe $S_i$ und die mittels Temperatursensoren 32 an verschiedenen Stellen innerhalb des Generatorgehäuses 4 gemessenen Temperaturen $T_{Gk}$ und $T_{Gw}$ eines den Generator 2 kühlenden zusätzlichen Kühlgases, z.B. Wasserstoff, zugeführt. Dabei sind $T_{Gk}$ und $T_{Gw}$ die Temperaturen des kühlen bzw. des erwärmten Kühlgases.

Dem Baustein 22 werden außerdem als weitere Meßsignale oder Meßwerte die Werte der drei Ständer-Phasenströme $I_u$, $I_v$ und $I_w$, der Generatorklemmenspannung U und der Blindleistung Q zugeführt, die über Trennverstärker 34 aus bestehenden und mit den Anschlußklemmen 36 der Standerwicklung 10 verbundenen (nicht dargestellten) Meßkreisen ausgeblendet werden. Diese Meßwerte $I_u$, $I_v$, $I_w$, U, Q, die Temperaturen $T_{Wk}$, $T_{Ww}$ und die Drücke $p_k$, $p_w$ des Kühlwassers KW sowie die Temperaturen $T_{Gk}$, $T_{Gw}$ des Kühlgases bilden m betriebsrelevante Parameter $P_j = P_1, ... , P_m$.

Der Baustein 22 dient zur Grenzwertüberwachung oder Plausibilitätskontrolle sowie zur Analog-/Digital-Wandlung der Meßwerte der Stabtemperaturen $T_i$ und der Parameter Pj. Außerdem dient er zum Aufbauen von Datentelegrammen sowie zur Signalbildung für Warnungen und Störungen.

Der Baustein 22 ist über einen Datenbus 38 mit einem weiteren Baustein 40 zur Überwachung der Temperaturen $T_i$ der Wicklungsstäbe $S_i$ verbunden. Dieser umfaßt eine erste Rechnereinheit 42 zur Berechnung stabspezifischer Kenngrößen $K_{ij}$. Diese werden für jeden der $i = 1, ... , n$ Wicklungsstäbe $S_i$ mittels eines Polynoms der Form

$$T_{iR} = a \sum_{j=1}^{m} k_{ij} \cdot f_j (P^*_j)$$

aus einer Referenzmessung abgeleitet. Dabei sind $T_{iR}$ die bei der Referenzmessung erfaßte Temperatur des i-ten Wicklungsstabes $S_i$ und $f_j (P^*_j)$ m Funktionen der $j = 1, ... , m$ betriebsrelevanten Parameter $P^*_j$. Die Funktion $f_j$ der Einflußgrößen oder Parameter $P_j$ sind aus Erfahrungswerten abgeleitet und aufgrund technischer Zusammenhänge definiert, wobei z.B. bei m = 6 Funktionen $f_1 = 1$, $f_2 = I^2$, $f_3 = I^2 \cdot T_{Ww}$, $f_4 = U^2$, $f_5 = T_{Wk} - T_{Gk}$ und $f_6 = Q$ sind. Dabei können die Positionen der Funktionen $f_j$ im Polynom auch vertauscht sein, z.B. wenn ein technischer Zusammenhang dadurch präzisiert werden kann, daß $f_2 = U^2$ und $f_4 = I^2$ ist. In dem Faktor a ist der Volumenstrom V des Kühlwassers KW oder der auf den höchsten Betriebsdruck normierte Differenzdruck $\Delta p = p_w - p_k$ des Kühlwassers KW über der Ständerwicklung 10 berücksichtigt, wobei $a = (1/V)^b$ bzw. $a = (\Delta p_{normiert}/\Delta p)^c$ ist. Dabei sind $b < 2$ und $c < 3$, z.B. $b = c = 1/2$. Das Polynom für den i-ten Wicklungsstab $S_i$ ist somit proportional dessen bei der Referenzmessung erfaßten Temperatur $T_{iR}$, d.h.

$$T_{iR} \propto \sum_{j=1}^{m} k_{ij} \cdot f_j\ (P^{\star}_j).$$

Bei der Referenzmessung werden die Funktionsverläufe der einzelnen betriebsrelevanten Parameter $P^{\star}_j$ bei unterschiedlichen Betriebs- oder Last zuständen am "gesunden Generator" aufgenommen, das heißt unter der Voraussetzung, daß ein störungs- oder fehlerfreier Betrieb des Generators, z.B. vor dessen Inbetriebnahme, vorliegt. Die Ermittlung der Funktionsverläufe erfolgt in einer Rechnereinheit 44. Die in der Rechnereinheit 42 aus diesen Funktionen $f_j\ (P^{\star}_j)$ und aus den Temperaturen $T_{iR}$ der Wicklungsstäbe Si ermittelten Koeffizienten $k_{ij}$ des Polynoms, die die jeweils m Kenngrößen der n Wicklungsstäbe $S_i$ darstellen, werden in einem Speicher 46 abgelegt. Die Kenngrößen $k_{ij}$ und ihre relativen Größen RG sind in einem Balkendiagramm 48 veranschaulicht.

Bei einer aktuellen Überwachung werden bei einem beliebigen Betriebszustand des Generators 2 zunächst innerhalb eines einstellbaren Meßzyklus, z.B. innerhalb eines Zeitraums von drei bis fünfzehn Minuten, die betriebsrelevanten Parameter $P_j$ gemessen. Der Zeitraum hängt im wesentlichen ab von den Zeitkonstanten der Temperatursensoren 21. Sind diese Meßwerte der Parameter $P_j$ innerhalb dieses Meßzyklus konstant oder liegen sie innerhalb eines vorgebbaren Toleranzbandes, so hat der Generator 2 einen Zustand der thermischen Beharrung erreiche. Dabei werden für jeden Parameter $P_j$ die periodisch eingelesenen Meßwerte verglichen mit denen einer vorherigen Periode des Meßzyklus. Wird keine Abweichung festgestellt oder liegen die Abweichungen innerhalb des Toleranzbandes, so liegt thermische Beharrung vor. Am Ende des Meßzyklus werden die Temperaturen $T_i$ der n Wicklungsstäbe $S_i$ eingelesen. Nach dem Einlesen der Temperaturen $T_i$ werden die Meßwerte der Parameter $P_j$ erneut eingelesen und überprüft. Sind die Meßwerte der Parameter $P_j$ weiterhin konstant, so werden sie einer sogenannten statischen Bewertung zugrundegelegt. Werden dagegen Abweichungen bei einem oder mehreren der betriebsrelevanten Parameter $P_j$ festgestellt, so können die zuletzt erfaßten Meßwerte einer sogenannten dynamischen Bewertung zugrundegelegt werden. Sowohl bei der statischen Bewertung als auch bei der dynamischen Bewertung werden aus den Meßwerten der aktuellen Parameter $P_j$ in der Rechnereinheit 44 die entsprechenden Funktionswerte $f_j\ (P_j)$ gebildet. In einer weiteren Rechnereinheit 50 wird aus diesen Funktionswerten $f_j\ (P_j)$ für jeden Wicklungsstab $S_i$ ein Referenzwert $T_{iRS}$ ermittelt. Dazu wird der Referenzwert $T_{iRS}$ des i-ten Wicklungsstabes $S_i$ berechnet aus einem Polynom der Form

$$T_{iRS} = a \sum_{j=1}^{m} k_{ij} \cdot f_j\ (P_j),$$

wobei die Funktionswerte $f_j\ (P_j)$ der aktuell ermittelten Parameter $P_j$ und die aus der Referenzmessung ermittelten Koeffizienten $k_{ij}$ aus dem Speicher 46 eingesetzt werden. Der Referenzwert $T_{iRS}$ des i-ten Wicklungsstabes $S_i$ ist somit proportional dem aus den gespeicherten Koeffizienten $k_{ij}$ und aus einem beliebigen Datensatz von Funktionswerten $f_j\ (P_j)$ gebildeten Polynom.

Zur Ermittlung einer Temperaturabweichung $\Delta T_i$ wird der in der Rechnereinheit 50 ermittelte Referenzwert $T_{iRS}$ des i-ten Wicklungsstabes $S_i$ in einer Vergleichsstufe 52 mit dem aktuell gemessenen Ist-Wert der Temperatur $T_{iM}$ des i-ten Wicklungsstabes $S_i$ verglichen. Weicht der gemessene Ist-Wert $T_{iM}$ von dem Referenzwert $T_{iRS}$ ab und liegt diese Abweichung $\Delta T_i$ außerhalb eines vorgebbaren Toleranzbandes, so wird eine Meldung oder ein Signal S erzeugt, das in nicht näher dargestellter Art und Weise an eine Leitwarte abgegeben wird. Aus einer zeitlichen Änderung einer Temperaturabweichung $\Delta T_i$ oder aus einer Abweichung gegenüber einem vorherigen Wert $\Delta T_i$ kann auch eine Erwärmungsänderung $\Delta(\Delta T_i)$ des entsprechenden Wicklungsstabes $S_i$ ermittelt werden.

Mittels dieses Verfahrens, bei dem eine Temperaturüberwachung jedes Wicklungsstabes $S_i$ unter Berücksichtigung der betriebsrelevanten Parameter $P_j$ oder betriebsbedingter Einflußgrößen erfolgt, können für jeden Wicklungsstab $S_i$ aus einer festgestellten Temperaturabweichung $\Delta T_i$ oder Erwärmungsänderung $\Delta(\Delta T_i)$ Rückschlüsse auf deren Ursache gezogen werden.

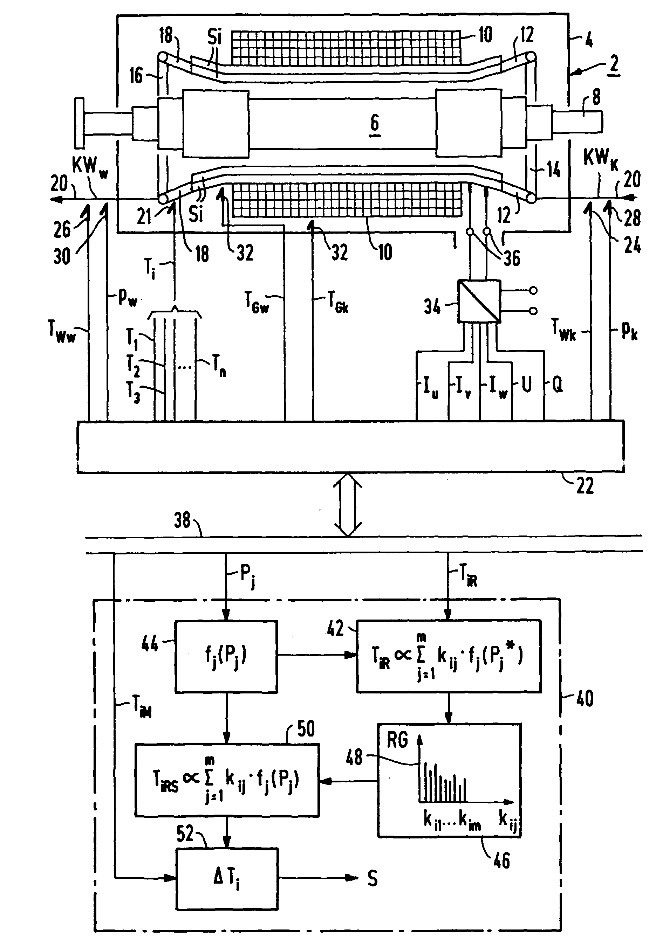

**Patentansprüche**

1. Verfahren zur Temperaturüberwachung eines elektrischen Generators (2), bei dem die Temperaturen ($T_i$) einer Vielzahl von Wicklungsstäben ($S_i$) der mit einem Kühlmittel (KW) gekühlten, vorzugsweise wassergekühlten, Ständerwicklung (10) des Generators (2) erfaßt werden, und bei dem für jeden Wicklungsstab ($S_i$) zur Ermittlung einer Temperaturabweichung $\Delta T_i$ ein gemessener Ist-Wert der Temperatur $T_{iM}$ dieses Wicklungsstabes ($S_i$) vergli-

chen wird mit einem Referenzwert $T_{iRS}$ für diesen Wicklungsstab ($S_i$), wobei der Referenzwert $T_{iRS}$ gebildet wird aus für diesen Wicklungsstab ($S_i$) zuvor aus einer Referenzmessung ermittelten Kenngrößen $k_{ij}$ und aus aktuell erfaßten betriebsrelevanten Parametern $P_j$ des Generators (2), wobei die Kenngrößen $k_{ij}$ für jeden Wicklungsstab ($S_i$) ermittelt werden aus einer bei der Referenzmessung erfaßten Temperatur $T_{iR}$ dieses Wicklungsstabes ($S_i$) und aus einer der Anzahl der Kenngrößen $k_{ij}$ gleichen Anzahl von Funktionen $f_j$, die von den betriebsrelevanten Parametern $P_j$ abhängig und für die bei der Referenzmessung bei unterschiedlichen Betriebszuständen des Generators (2) erfaßten betriebsrelevanten Parameter $P^*_j$ ausgewertet sind, und wobei sowohl die aktuell erfaßten betriebsrelevanten Paramenter $P_j$ als auch die bei der Referenzmessung erfaßten betriebsrelevanten Parameter $P^*_j$ zusätzlich zum Ständerstrom (I) des Generators (2) jeweils mindestens einen der folgenden Parameter umfassen: die Klemmenspannung (U) des Generators (2), die Blindleistung (Q), die Temperatur ($T_{Ww}$, $T_{Wk}$) des Kühlwassers ($KW_k$, $KW_w$) vor und nach Durchtritt durch die Wicklungsstäbe ($S_i$), die Temperatur ($T_{Gk}$, $T_{Gw}$) eines im Generator (2) enthaltenen zusätzlichen Generatorkühlmittels, wie z.B. Wasserstoff.

2. Verfahren nach Anspruch 1,
**dadurch gekennzeichnet,** daß zur Ermittlung der Kenngrößen $k_{ij}$ des i-ten Wicklungsstabes ($S_i$) ein Polynom der Form

$$T_{iR} \propto \sum_{j=1}^{m} k_{ij} \cdot f_j (P^*_j)$$

gebildet wird, wobei $f_j (P^*_j)$ die für die bei der Referenzmessung erfaßten betriebsrelevanten Parameter $P^*_j$, ausgewerteten m Funktionen $f_j$, $k_{ij}$ die die entsprechenden Kenngrößen darstellenden m Koeffizienten und $T_{iR}$ die bei der Referenzmessung erfaßte Temperatur des i-ten Wicklungsstabes ($S_i$) sind.

3. Verfahren nach Anspruch 1 oder 2,
**dadurch gekennzeichnet**, daß der Referenzwert $T_{iRS}$ ermittelt wird aus einem Polynom der Form

$$T_{iRS} \propto \sum_{j=1}^{m} k_{ij} \cdot f_j (P_j),$$

wobei $f_j(P_j)$ Funktionswerte von bei einem beliebigen Betriebszustand gemessenen betriebsrelevanten Parametern $P_j$, $k_{ij}$ die die Kenngrößen darstellenden m Koeffizienten und $T_{iRS}$ der daraus ermittelte Referenzwert der Temperatur des i-ten Wicklungsstabes ($S_i$) sind.

4. Verfahren nach einem der Ansprüche 1 bis 3,
**dadurch gekennzeichnet,** daß die zur Bildung des Referenzwertes $T_{iRS}$ dienenden betriebsrelevanten Parameter $P_j$ bei einem aktuellen Betriebszustand innerhalb eines einstellbaren Meßzyklus periodisch gemessen werden, wobei jeder gemessene Wert eines parameters $P_j$ zur Feststellung einer Abweichung mit dem Wert einer vorherigen Periode des Meßzyklus verglichen wird.

5. Vorrichtung zur Temperaturüberwachung eines elektrischen Generators (2), dessen mit einem Kühlmittel (KW) gekühlte, vorzugsweise wassergekühlte, Ständerwicklung (10) eine Vielzahl von Wicklungsstäben ($S_i$) aufweist, mit einem ersten Baustein (22) zur Erfassung und Verarbeitung eines Temperaturmeßwertes $T_{iM}$ für jeden Wicklungsstab ($S_i$), **gekennzeichnet durch** einen mit dem ersten Baustein (22) über einen Datenbus (38) verbundenen zweiten Baustein (40) zur Ermittlung einer Temperaturabweichung $\Delta T_i$ eines gemessenen stabspezifischen Ist-Wertes $T_{iM}$ von einem stabspezifischen Referenzwert $T_{iRS}$ für jeden Wicklungsstab ($S_i$), wobei der zweite Baustein (40) eine erste Rechnereinheit (42) zur Berechnung von aus einer Referenzmessung gebildeten Kenngrößen $k_{ij}$ und eine zweite Rechnereinheit (50) zur Berechnung der stabspezifischen Referenzwerte $T_{iRS}$ aus den aus der Referenzmessung gebildeten Kenngrößen $k_{ij}$ sowie aus aktuell erfaßten betriebsrelevanten Parametern $P_j$ des Generators (2) umfaßt, und wobei mittels des ersten Bausteins (22) als aktuelle betriebsrelevante Parameter $P_j$ zusätzlich zum Ständerstrom (I) mindestens einer der folgenden Parameter erfaßbar ist: die Klemmenspannung (U) des Generators (2), die Blindleistung (Q), die Temperatur ($T_{Ww}$, $T_{Wk}$) des Kühlwassers ($KW_k$, $KW_w$) vor und nach Durchtritt durch die Wicklungsstäbe ($S_i$), die Temperatur ($T_{Gk}$, $T_{Gw}$) eines im Generator (2) enthaltenen zusätzlichen Generatorkühlmittels, wie z.B. Wasserstoff.

6. Vorrichtung nach Anspruch 5,
**dadurch gekennzeichnet**, daß der zweite Baustein (40) einen Speicher (46) zum Ablegen der Kenngrößen $k_{ij}$ umfaßt.

**Claims**

1. Process for monitoring the temperature of an electric generator (2), in which process the temperatures ($T_i$) of a plurality of winding bars ($S_i$) of the

stator winding (10) of the generator (2), which stator winding is cooled with a coolant (KW), preferably with water, are detected, and in which for each winding bar ($S_i$), in order to establish a temperature deviation $\Delta T_i$, a measured actual value of the temperature $T_{iM}$ of this winding bar ($S_i$) is compared with a reference value $T_{iRS}$ for this winding bar ($S_i$), with the reference value $T_{iRS}$ being formed from characteristic variables $k_{ij}$, which were established previously for this winding bar ($S_i$) from a reference measurement, and from currently detected operation-relevant parameters $P_j$ of the generator (2), with the characteristic variables $k_{ij}$ for each winding bar ($S_i$) being established from a temperature $T_{iR}$ of this winding rod ($S_i$) detected in the case of the reference measurement and from a number of functions $f_j$ that is equal to the number of characteristic variables $k_{ij}$, which functions are dependent on the operation-relevant parameters $P_j$ and are evaluated for the operation-relevant parameters $P^*_j$ detected in the case of the reference measurement at different operating states of the generator (2), and with both the currently detected operation-relevant parameters $P_j$ and the operation-relevant parameters $P^*_j$ detected in the case of the reference measurement comprising in addition to the stator current (I) of the generator (2) in each case at least one of the following parameters: the terminal voltage (U) of the generator (2), the reactive power (Q), the temperature ($T_{Ww}$, $T_{Wk}$) of the cooling water ($KW_k$, $KW_w$) before and after passage through the winding bars ($S_i$), the temperature ($T_{Gk}$, $T_{Gw}$) of an additional generator coolant, for example hydrogen, contained in the generator (2).

2. Process according to claim 1, characterised in that in order to establish the characteristic variables $k_{ij}$ of the i-th winding bar ($S_i$), a polynomial of the form

$$T_{iR} \propto \sum_{j=1}^{m} k_{ij} \cdot f_j \ (P^*_j)$$

is formed, in which case $f_j \ (P^*_j)$ is the m functions $f_j$ evaluated for the operation-relevant parameters $P^*_j$ established in the case of the reference measurement, $k_{ij}$ is the m coefficients representing the corresponding characteristic variables, and $T_{iR}$ is the temperature of the i-th winding bar ($S_i$) that is detected in the case of the reference measurement.

3. Process according to claim 1 or 2, characterised in that the reference value $T_{iRS}$ is established from a polynomial of the form

$$T_{iRS} \propto \sum_{j=1}^{m} k_{ij} \cdot f_j \ (P_j),$$

in which case $f_j \ (P_j)$ is function values of operation-relevant parameters $P_j$ measured in any operating state, $k_{ij}$ is the m coefficients representing the characteristic variables, and $T_{iRS}$ is the reference value, established therefrom, of the temperature of the i-th winding bar ($S_i$).

4. Process according to one of the claims 1 to 3, characterised in that the operation-relevant parameters $P_j$ which are used to form the reference value $T_{iRS}$ are measured periodically in a current operating state within an adjustable measurement cycle, with each measured value of a parameter $P_j$ being compared with the value of a previous period of the measurement cycle, in order to establish a deviation.

5. Device for temperature monitoring an electric generator (2), the stator winding (10) of which, which stator winding is cooled with a coolant (KW), preferably with water, has a plurality of winding bars ($S_i$), having a first module (22) for detecting and processing a measured temperature value $T_{iM}$ for each winding bar ($S_i$), characterised by a second module (40), which is connected to the first module (22) via a data bus (38), for establishing a temperature deviation $\Delta T_i$ of a measured bar-specific actual value $T_{iM}$ from a bar-specific reference value $T_{iRS}$ for each winding bar ($S_i$), with the second module (40) having a first computer unit (42) for calculating characteristic variables $k_{ij}$ formed from a reference measurement, and a second computer unit (50) for calculating the bar-specific reference values $T_{iRS}$ from the characteristic variables $k_{ij}$, which are formed from the reference measurement, as well as from currently detected operation-relevant parameters $P_j$ of the generator (2), and with at least one of the following parameters being detectable by means of the first module (22) as current operation-relevant parameters $P_j$, in addition to the stator current (I): the terminal voltage (U) of the generator (2), the reactive power (Q), the temperature ($T_{Ww}$, $T_{Wk}$) of the cooling water ($KW_k$, $KW_w$) before and after passage through the winding bars ($S_i$), the temperature ($T_{Gk}$, $T_{Gw}$) of an additional generator coolant, for example hydrogen, contained in the generator (2).

6. Device according to claim 5, characterised in that the second module (40) comprises a memory (46) for storing the characteristic variables $k_{ij}$.

## Revendications

1. Procédé de contrôle de la température d'une génératrice électrique (2), dans lequel on détecte les températures ($T_i$) d'une multiplicité de barres ($S_i$) d'enroulement de l'enroulement statorique (10), refroidi par un fluide (KW) de refroidissement, de préférence refroidi à l'eau, de la génératrice (2) et dans lequel on compare pour chaque barre ($S_i$) d'enroulement, pour déterminer un écart de température $\Delta T_i$, une valeur réelle mesurée de la température $T_{iM}$ de cette barre ($S_i$) d'enroulement à une valeur de référence $T_{iRS}$ pour cette barre ($S_i$) d'enroulement, la valeur $T_{iRS}$ de référence étant formée de grandeurs caractéristiques $k_{ij}$ déterminées auparavant pour cette barre ($S_i$) d'enroulement à partir d'une mesure de référence et de paramètres $P_j$ du générateur 2 détectés actuellement et déterminants pour le fonctionnement, les grandeurs caractéristiques $k_{ij}$ pour chaque barre ($S_i$) d'enroulement étant déterminées à partir d'une température $T_{iR}$, détectée pour la mesure de référence, de cette barre ($S_i$) d'enroulement et à partir d'un nombre de fonctions $f_j$, qui est le même que le nombre de grandeurs caractéristiques $k_{ij}$, qui dépendent des paramètres $P_j$ déterminants pour le fonctionnement et qui sont exploitées pour les paramètres $P^*_j$ déterminants pour le fonctionnement et détecté lors de la mesure de référence pour différents états de fonctionnement de la génératrice (2), et à la fois les paramètres $P_j$ déterminants pour le fonctionnement détectés actuellement et les paramètres $P^*_j$ détectés lors de la mesure de référence et déterminants pour le fonctionnement comprennent, en plus du courant (I) statorique de la génératrice (2) au moins l'un des paramètres suivants: la tension (U) aux bornes de la génératrice (2), la température ($T_{Ww}$, $T_{Wk}$) de l'eau de refroidissement ($KW_k$, $KW_W$) avant et après le passage dans les barres ($S_i$) d'enroulement, la température ($T_{Gk}$, $T_{Gw}$) d'un fluide de refroidissement de la génératrice supplémentaire contenu dans la génératrice (2), comme par exemple de l'hydrogène.

2. Procédé suivant la revendication 1, caractérisé en ce qu'on forme pour déterminer les grandeurs caractéristiques $k_{ij}$ de la i-ième barre ($S_i$) d'enroulement un polynôme de la forme

$$T_{iR} \propto \sum_{j=1}^{m} k_{ij} \cdot f_j (P^*_j)$$

$f_j (P^*_j)$ étant les m fonctions exploitées pour les paramètres $P^*_j$ déterminants pour le fonctionnement et détectés lors de la mesure de référence, $k_{ij}$ étant

les m coefficients représentant les grandeurs caractéristiques correspondantes et $T_{iR}$ étant la température, détectée lors de la mesure de référence, de la i-ième barre ($S_i$) d'enroulement.

3. Procédé suivant la revendication 1 ou 2, caractérisé en ce que l'on détermine la valeur $T_{iRS}$ de référence à partir d'un polynôme de la forme

$$T_{iRS} \propto \sum_{j=1}^{m} k_{ij} \cdot f_j (P_j),$$

$f_j (P_j)$ étant des valeurs de fonction de paramètres $P_j$ déterminants pour le fonctionnement et mesurés pour un état de fonctionnement quelconque, $k_{ij}$ étant les m coefficients représentant les grandeurs caractéristiques et $T_{iRS}$ étant la valeur de référence, déterminée à partir de là, de la température de la i-ième barre ($S_i$) d'enroulement.

4. Procédé suivant l'une des revendications 1 à 3, caractérisé en ce que on mesure périodiquement les paramètres $P_j$ déterminants pour le fonctionnement et servant à la formation de la valeur de référence $T_{iRS}$ pour un état actuel de fonctionnement dans un cycle de mesure pouvant être réglé, chaque valeur mesurée d'un paramètre $P_j$ étant comparée, pour fixer un écart, à la valeur d'une période précédente du cycle de mesure.

5. Dispositif pour le contrôle de la température d'une génératrice électrique (2), dont l'enroulement statorique (10) refroidi par un fluide de refroidissement (KW), de préférence refroidi par de l'eau, comporte une multiplicité de barres ($S_i$) d'enroulement, comportant un premier module (22) de détection et de traitement d'une valeur $T_{iM}$ de mesure de la température pour chaque barre ($S_i$) d'enroulement, caractérisé par un deuxième module (40), qui est relié au premier module (22) par l'intermédiaire d'un bus (38), de données et qui est destiné à la détermination d'un écart $\Delta T_i$ de température d'une valeur réelle $T_{iM}$ mesurée spécifique à la barre par rapport à une valeur $T_{iRS}$ de référence spécifique de la barre pour chaque barre ($S_i$) d'enroulement, le deuxième module (40) comprenant une première unité (42) de calcul de grandeurs caractéristiques $k_{ij}$ formées à partir d'une mesure de référence et une deuxième unité (50) de calcul des valeurs des références spécifiques à la barre $T_{iRS}$ à partir des grandeurs caractéristiques $k_{ij}$ formés à partir de la mesure de référence ainsi qu'à partir de paramètres $P_j$ de la génératrice (2), qui sont déterminants pour le fonctionnement et qui sont détectés actuellement, et au moins l'un des paramètres suivants pouvant être détecté au moyen du premier module (22) en tant que paramètre $P_j$ actuel déterminant pour le fonctionnement en plus du courant statorique (I) : la tension (U) aux bornes de la génératrice (2), la puissance réactive (Q), la température ($T_{Ww}$, $T_{Wk}$) de l'eau de refroidissement ($KW_k$, $KW_w$) avant et après le passage dans les barres ($S_i$) d'enroulement, la température ($T_{Gk}$, $T_{Gw}$) d'un fluide de refroidissement supplémentaire de la génératrice contenuu dans la génératrice (2), comme par exemple de l'hydrogène.

6. Dispositif suivant la revendication 5, caractérisé en ce que le deuxième module (40) comprend une mémoire (46) pour la mémorisation des grandeurs caractéristiques $k_{ij}$.